# EUROPEAN PATENT APPLICATION

(11) **EP 1 950 236 A1**
(43) Date of publication of application: **30.07.2008**
(21) Application number: 06832729.5
(22) Date of filing: 16.11.2006
(51) Int. Cl.: C08G 61/00, B29C 45/00, B29C 45/14, C08K 3/26, C08K 7/10, C08L 65/00, B29K 45/00, B29K 105/12

(54) **NORBORNENE RESIN MOLDINGS AND PROCESS FOR PRODUCTION THEREOF**

(30) Priority: 18.11.2005 JP 2005334719
(71) Applicant: Rimtec Corporation, Tokyo 1008246 (JP)
(72) Inventor: TAKIMOTO, Tomohiko, Tokyo 1008246 (JP); MIURA, Takahiro, Tokyo 1008246 (JP)
(74) Representative: Albrecht, Thomas
(86) International application number: PCT/JP2006/322840
(87) International publication number: WO 2007/058249

(57) **Abstract**

A norbornene-based resin molded article obtained by bulk polymerizing a norbornene-based monomer in a mold; wherein said norbornene-based resin molded article is **characterized by** comprising a hybrid filler obtained by high-speed mixing the two or more kinds of fillers in dry method. Preferably, said hybrid filler is obtained by high-speed mixing, at least a fibrous filler having 5 to 100 aspect ratio and a particulate filler having 1 to 2 aspect ratio, in dry method. The present invention provides the norbornene-based resin molded article superior in rigidity and dimensional stability; and the method of production thereof.

## Description

### TECHNICAL FIELD

The present invention relates to a norbornene-based resin molded article obtained by bulk polymerization of norbornene-based monomer in the mold and the method of production thereof. Further specifically, the present invention relates to a norbornene-based resin molded article superior in rigidity and dimensional stability; and the method of production thereof.

### BACKGROUND OF THE ART

It has been put to practical use to produce a molded article made of norbornene-based resin by the reaction injection molding (RIM) method comprising injecting a reaction mixturte including norbornene-based monomers and metathesis catalysts into a mold and subjecting the mixture to bulk polymerization via ring opening. The reaction mixture is usually obtained by mixing two or more reaction stock solutions instantaneously in a collisional mixer, etc. Each of the reaction stock solution is not able to be bulk polymerized alone, but when all mixed to produce a reaction mixture containing a each component in predetermined ratio, a norbornene-based monomer is bulk polymerized.

It is known to form a molded article by adding various types of fillers to the reaction mixture for the purpose to provide rigidity and dimensional stability in a molded article obtained by the RIM method. However, in the conventional methods, the molded article may be insufficient in rigidity. Also, the fillers are used by adding them to the reaction stock solutions, however when the reaction stock solutions comprises the fillers, the storing stability was liable to be low.

For example, Patent Article 1 and 2 proposes to use glass fiber, wollastonite or the like as filler. However, in case these fibrous fillers were used, there was a problem that the injection nozzle be clogged during the injections into the mold when large amounts of fillers were added to the reaction mixture. Therefore, these patent articles weren't able to establish sufficient rigidity. Also, the use of calcium carbonate having specific particle size and etc. as a filler is proposed (for example Patent Article 3). However, the effect of the improvement of the rigidity was insufficient using this method.

Furthermore, in the Patent Article 1~3, there were problems such as pipe clogging due to the precipitation of filler in the reaction stock solutions and resulting molded article being ununiform.

[Patent Article 1] The Japanese Unexamined Patent Publication S58-129013
[Patent Article 2] The Japanese Unexamined Patent Publication H2-185558
[Patent Article 3] The Japanese Unexamined Patent Publication 2003-321597

### DISCLOSURE OF THE INVENTION

### PROBLEMS TO BE SOLVED BY THE INVENTION

The present invention was made reflecting above mentioned situation. The purpose of the present invention is to provide a resin molded article superior in rigidity and dimensional stability, and the method of production thereof.

### MEANS FOR SOLVING THE PROBLEM

As the result of the keen examination to achieve above mentioned purpose, the inventors has found that the above mentioned purpose can be achieved by intoducing a hybrid filler (complex filler) obtained by high-speed mixing two or more kinds of fillers in dry method to the molded article. Based on this finding the present invention was achieved.

That is, the norbornene-based resin molded article according to the present invention is a norbornene- based resin molded article obtained by bulk polymerizing the norbornene-based monomer in a mold; and it is characterized by including a hybrid-filler obtained by high-speed mixing two or more kinds of fillers in dry method.

Preferably, said hybrid filler is a filler obtained by high-speed mixing at least a fibrous filler having an aspect ratio of 5 to 100 and a particulate filler having an aspect ratio of 1 to 2 in dry method.
Preferably, said fibrous filler is a wollastonite.
Preferably, said particulate filler is a calcium carbonate.
Preferably, the ratio of said fibrous filler and particulate filler is, in weight ratio, fibrous filler : particulate filler = 95 : 5 to 50 : 50.
Preferably, the surface of said hybrid filler is treated with a silane coupling agent and/or a titanate coupling agent.
Preferably, the norbornene-based resin molded article of the present invention is a complex molded article co-formed with a complex giving member.
Preferably, a plating layer is formed on surface of the norbornene-based resin molded article of the present invention.
Preferably, a norbornene-based resin molded article of the present invention comprises; a first plating layer formed on the surface of the norbornene-based resin molded article and a second plating layer formed on the surface of the first plating layer by electroplating.

The production method of the norbornene-based resin molded article according to the present invention is a method to produce any one of said resin molded article characterized by injecting the reaction mixture comprised of said norbornene-based monomer, a metathesis catalyst and said hybrid filler in the mold to carry out bulk polymerization.

In the method of production of the norbornene-based resin molded article according to the present invention, the complex giving member is placed within the mold.

### EFFECTS OF THE INVENTION

The norbornene-based resin molded article of the present invention is excelent in rigidity and dimensional stability; thus it can be suitably used for various types and wide range of applications such as housing equipments, general architectural parts, electric parts, and car parts. Particularly, in the present invention, since the hybrid filler (complex filler) obtained from high-speed mixing two or more kinds of fillers in dry method is used, the precipitation of the filler is solved; and also the dispersion and re-dispersion of the filler into the reaction stock solution can be made good.
Thus, even when the added amount of filler was equivalent to that of the conventional amount, further improvement in rigidity and dimensional stability is possible.

Also, since the dispersion and re-dispersion of the filler into the reaction stock solution is good, the proportion of added amount of the filler can be increased in the reaction stock solution. As a result, the proportion of added amount in the resulting norbornene-based resin molded article can be increased. Moreover, since the proportion of added amount of the filler can be increased, further improvement in rigidity and dimensional stability of the norbornene-based resin molded article is possible.
Furthermore, when the plating layer is formed on the norbornene-based resin molded article of the present invention, in addition to the improvement of rigidity and dimensional stability, the adherence of the molded article to the plating layer is also good.

### THE BEST MODE FOR CARRYING OUT THE INVENTION

A norbornene-based resin molded article of the present invention (hereinafter may be referred to simply as a "molded article") is a molded article of norbornene-based resin obtained by bulk polymerizing a norbornene-based monomer in the mold; and characterized by comprising hybrid filler (complex filler) obtained by high-speed mixing two or more kinds of fillers in dry method.
A molded article of such invention can be produced by a method of production of the present invention. In the method of production of the present invention, a reaction mixture comprising a norbornene-based monomer, metathesis catalysts and the above mentioned hybrid filler is injected into the mold to carry out bulk polymerization therein.
First, the method of production of the present invention will be described.

### Reaction mixture

A reaction mixture used in the method of production of present invention is obtained by mixing reaction stock solutions composed of a norbornene-based monomer, the metathesis catalysts, the hybrid filler and optional components, which are contained in a norbornene-based resin molded article, wherein the stock solutions are usually prepared as two or more separate portions. That is, the reaction mixture is obtained by mixing two or more of the reaction stock solutions. Furthermore, each of the reaction stock solutions is not able to be bulk polymerized alone, but when all mixed to produce the reaction mixture containing each component in a predetermined ratio, a norbornene-based monomer is bulk polymerized.
Note that for the optional components, an activator, an activity regulator, an elastomer and an antioxidant may be mentioned.
First each component included in the reaction mixture will be described.

### Norbonene-based Monomer

The norbornene-based monomer used in the present invention is a compound having norbornene ring structure, and may be any one of these. Among these, it is preferable to use a polycyclic norbornene-based monomer having three or more rings so that a molded article superior in heat resistance can be obtained.

As the specific examples of norbornene-based monomer, norbornene, norbornadien and other bicyclic compounds; dicyclopentadiene (a dimer of cyclopemtadiene), dihydrodicyclopentadiene, and other tricyclic compounds; tetracyclododecene and other tetracyclic compounds; a trimer of cyclopentadiene and other pentacyclic compounds; a tetramer of cyclopentadiene and other heptacyclic compounds; substitution compounds of those mentioned above such as methyl, ethyl, propyl, butyl, and other alkyl substitution compounds, vinyl and other alkenyl substitution compounds, and ethylidene and other alkylidene substitution compopunds, phenyl, tolyl, naphthyl and other aryl substitution compounds; as well as substitution compounds of those mentioned above having polar groups such as ester, ether and cyano groups and halogen atoms; may be mentioned. These monomers may be used in combination of two or more of those. Tricyclic, tetracyclic, or pentacyclic monomers are preferable from the viewpoints of availability and high reactivity as well as excellent heat resistance of the resulting molded articles.

Furthermore, the produced ring-opening polymer is preferably a thermosetting type. For this purpose, among the above mentioned norbornene-based monomers, it is preferable to use at least a cross-linkable monomer having two or more reactive double bonds such as a symmetric trimer of cyclopentadiene. The ratio of such a cross-linkable monomer in the whole norbornene-based monomers is preferably 2 to 30 wt%.

Note that, monoyclic cycloolefin, etc., co-polymerizable via ring opening with norbornene-based monomers, such as cyclobutene, cyclopentene, cyclopentadiene, cyclooctene, cyclododecene can be used as a comonomer within the scope of the present invention.

### Hybrid Filler

The hybrid filler used in the present invention is a filler obtained by high-speed mixing two or more kinds of fillers in dry method.
The hybrid filler only needs to be a filler obtained by high-speed mixing of two or more kinds of fillers in dry method.
The mixing conditions during the high-speed mixing are not particularly limited, for example it can be obtained by using a henschel mixer and etc., with adjusting the rotary blade circumference speed (speed of the tip of the blade) to normally 10 to 60m/s, and preferably 15 to 55m/s.
By high-speed mixing two or more kinds of fillers to form hybrid-filler, the dispersibility of the filler into said norbornene-based monomer can be higher.

Also, as for the two or more kinds of fillers constituting a hybrid filler, it is not particularly limited, however in the present invention, a preferable hybrid filler comprises at least a fibrous filler and a particulate filler, wherein the hybrid filler is obtained by high-speed mixing these fibrous filler and particulate filler in dry method. In particular, by using such fibrous and particulate filler, the effect of the present invention is to be even more prominent.

The fibrous filler used in the present invention is a solid material insoluble in a norbornene-based monomer and has an aspect ratio of 5 to 100. The aspect ratio is preferably 10 to 50 and more preferably 15 to 35. When the aspect ratio is excessively small, rigidity and dimensional stability of a resulting molded article may be insufficient. On the other hand, when it is excessively large, injection nozzle is liable to be clogged on injection into a mold.

Note that the aspect ratio of the filler in the present invention indicates a ratio of an average length of the long axis and 50%-volume cumulative diameter for the filler. The average length of the long axis is a numerical average length of the long axis obtained by measuring length of the long axes of 100 fillers randomly selected in an optical microscope picture and calculating the arithmetic mean value. Also, the 50%-volume cumulative diameter is a value obtained by measuring particle size distribution of the filler in the X-ray transmission method.

The 50%-volume cumulative diameter of the fibrous filler is preferably 0.1 to 50 µm and more preferably 1 to 30 µm. When the 50%-volume cumulative diameter is excessively small, rigidity and dimensional stability of a resulting molded article may be insufficient. On the other hand, when it is excessively large, the filler may precipitate in a tank and a pipe, or injection nozzle may be clogged in injecting the reaction mixture into a mold.

As a specific example for the fibrous filler, glass fiber, wollastonite, potassium titanate, zonolite, basic magnesium sulfate, aluminum borate, tetrapod-shaped zinc oxide, plaster fiber, phosphate fiber, alumina fiber, needle-like calcium carbonate, and needle-like boehmite, etc. may be mentioned. Among these, wollastonite is preferable, which is capable to improve rigidity even when using it in a small amount and does not block bulk polymerization.

A particulate filler is a solid material insoluble in a norbornene-based monomer and has an aspect ratio of 1 to 2. The aspect ratio is preferably 1 to 1.5. Also, the 50%-volume cumulative diameter of the particulate filler is preferably 0.1 to 50 pm, and more preferably 1 to 30µm. When the 50%-volume cumulative diameter is excessively small, rigidity and dimensional stability of a resulting molded article may be insufficient. On the other hand, when it is excessively large, the filler may precipitate in a tank and a pipe, or injection nozzle may be clogged in injecting the reaction mixture into a mold.

As a specific example for the particulate filler, calcium carbonate, calcium silicate, calcium sulfate, aluminum hydroxide, magnesium hydroxide, titanium oxide, zinc oxide, barium titanate, silica, alumina, carbon black, graphite, antimony oxide, red phosphorus, various types of metal powder, clay, various types of ferrite, hydrotalcite, etc. may be mentioned. The particulate filler may have a hollow body. Among these, calcium carbonate is preferable since it does not block bulk polymerization.

In case of the use of these fibrous filler and particulate filler, these ratio, in weight ratio, is preferably within the range of; fibrous filler : particulate filler = 95:5 to 5:95, more preferably 95:5 to 50:50, and further preferably 80:20 to 60:40.
By making the ratio of fibrous filler and particulate filler within the above range, the resulting molded article can be improved in rigidity and dimensional stability and at the same time it can be made uniform.

Furthermore, by high-speed mixing the above mentioned fibrous filler and particulate filler in dry method to produce a hybrid filler including these fibrous filler and particulate filler, the following effects can be obtained. That is, the aggregate of the fibrous filler and the particulate filler can be disintegrated. Moreover these fillers can be distributed uniformly, thus when included in the reaction stock solution, the dispersibility can be improved. Hence, it can be ditributed in the resulting molded article nicely which improves the effect of addition of these fillers even more.

Note that, when the hybrid filler is prepared by high-speed mixing two or more kinds of fillers (for example, fibrous filler and particulate filler) in dry method, the surface is preferably hydrophobized. By hydrophobizing, the dispersibility into a reaction stock solution can be further improved which results in further improvement of the rigidity and dimensional stability of the resulting molded article. As for the agent for the hydrophobization, a silane coupling agent, a titanate coupling agent, an aluminum coupling agent, a fatty acids, fats and oils, surfactant, wax and other macromolecules may be mentioned. A silane coupling agent and a titanate coupling agent are particularly preferred. Note that, these may be used in combination.

The method of hydrophobizing the hybrid filler is not particularly limited, and for example; (1) method of combining each filler constituting the hybrid filler and the hydrophobizing agent and conducting high-speed mixing in dry method, (2) method of combining each filler and conducting high-speed mixing in dry method followed by the addition of the hydrophobizing agent and further conducting high-speed mixing in dry method, and (3) method of adding the hydrophobizing agent to each filler separately followed by conducting high-speed mixing in dry method, and mixing the resulting fillers followed by further high-speed mixing in dry method; may be mentioned. Among these, the above mentioned method (2) is preferable, and particularly in this case, when the hydrophobizing agents is added, it should be gradually added by spraying or so.

The content of the hybrid filler in the reaction mixture is preferably 5 to 35 wt% and more preferably 10 to 30 wt% with respect to 100 wt% of whole reaction mixture. The hybrid filler used in the present invention has high dispersibility into the reaction mixture; hence relatively large amount of hybrid filler can be added to the reaction mixture. As a result, further improvement of rigidity and dimensional stability of the resulting molded article is possible.

### Metathesis Catalyst

In the method of production of the present invention, a known metathesis catalyst can be used without particular limitation as far as it can polymerize a norbornene-based monomer via ring opening in the reaction injection molding (RIM) method.
As for such metathesis catalyst, compounds of transition metals of Group 5 and 6 in periodic table and metal carbene complex having metal atoms from Group 8 in periodic table as a central metal may be mentioned.

As a compound of transition metals of Group 5 and 6 in periodic table, for example, halide, oxyhalide, oxide, organic ammonium salt, oxyacid salt and heteropoly acid salt of these transition metals may be mentioned. Among these, halide, oxyhalide and organic ammonium salt are preferable; and organic ammonium is more preferable. Also, for the transition metals, molybdenum, tungsten and tantalum are preferred; and molybdenum and tungsten are more preferred.
As specific examples of particularly preferred metathesis catalyst, molybdic acid salt and tungstic acid salt of tridodecyl ammonium, molybdic acid salt and tungstic acid salt of methyltricaprylic ammonium, molybdic acid salt and tungstic acid salt of tri (tridecyl) ammonium; and molybdic acid salt and tungstic acid salt of trioctyl ammonium may be mentioned.

The amount of these compounds of transition metal of Group 5 or Group 6 in the periodic table used as a metathesis catalyst is usually 0.01 to 50 mmol and more preferably 0.1 to 20 mmol with respect to 1 mol of norbornene-based monomer in the reaction mixture.

The metal carbene complex having a Group 8 metal atom in the periodic table as a central metal has a structure (M=C) that a metal atom (M) is directly bonded to carbene carbon (>C:) in the complex, by bonding a carbene compound to central metal atom consisting of a Group 8 metal atom in the periodic table. The carbene compound indicates a collective term of compounds having a carbene carbon, i.e. methylene free radical.
As a Group 8 metal atom in the periodic table, ruthenium and osmium are preferable, and ruthenium is particularly preferable.
As a preferable specific example of the metal carbene complex, benzylidene (1,3-dimesityl imidazolidine-2-ylidene) (tricyclohexyl phosphine) ruthenium dichloride, benzylidene (1,3-dimesityl-4,5-dibromoimidazoline-2-ylidene) (tricyclohe xyl phosphine) ruthenium dichloride, and bis(tricyclohexyl phosphine) benzylidene ruthenium dichloride, etc. may be mentioned.

The amount of these metal carbene complexes used as a metathesis catalyst is usually 0.001 to 1 mmol and preferably 0.002 to 0 .1 mmol with respect to 1 mol of monomer in the reaction mixture.

When the amount of the metathesis catalyst is excessively small, the reaction takes a longer time due to the excessively low polymerization activity, so that the production efficiency tends to be reduced. On the other hand, when the amount is exsessively large, the reaction becomes too severe, bulk polymerization starts before the reaction mixture is sufficiently injected in a mold, and it is difficult to store the reaction stock solution homogeneously since the catalyst is easily deposited.

The metathesis catalyst can be dissolved or dispersed in a small amount of inactive solvent. As the inactive solvent in such a case, for example, pentane, hexane, heptane and other chain aliphatic hydrocarbon solvents; cyclopentane, cyclohexane, methylcyclohexane, decahydronaphthalene, tricyclodecane, cyclooctane and other alicyclic hydrocarbon solvents; benzene, toluene, xylene and other aromatic hydrocarbon solvents; diethyl ether, tetrahydrofuran and other ether based solvents; may be used. Also, if it does not reduce the catalyst activity, a solution Antioxidant, a plasticizer and an elastomer may be used as the solvent. Among the above solvents, an aromatic hydrocarbon solvent, a chain aliphatic hydrocarbon solvent and an alicyclic hydrocarbon solvent, widely industrially used, are preferable.

### Optional Component

An activator is used to induce a polymerization activity in the metathesis catalyst when the metathesis catalyst doesn' t possess a polymerization activity alone. As an activator, ethyl aluminum dichloride, diethyl aluminum chloride and other alkyl aluminum halides; an alkoxyalkyl aluminum halide in which a part of alkyl groups in the alkyl aluminum halide is substituted with an alkoxy group; an organic tin compound; may be used. The amount of the activator is not particularly limited, but is usually 0.1 to 100 mol and preferably 1 to 10 mol with respect to 1 mol of the metathesis catalyst used in the whole reaction mixture.

An activity regulator has an effect to change the reaction speed, the time from the mixing of the reaction mixture to the beginning of the reaction, the reaction activity and the like.
As an activity regulator when a compound of a transition metal of Group 5 or Group 6 in the periodic table is used as a metathesis catalyst, compounds having an effect to reduce the metathesis catalyst, etc. may be mentioned, and alcohols, halo alcohols, esters, ethers, nitriles etc. can be used. Among these, alcohols and halo alcohols are preferable, and halo alcohols are particularly preferable. As a specific example of the alcohols, n-propanol, n-butanol, n-hexanol, 2-butanol, isobutyl alcohol, isopropyl alcohol, t-butyl alcohol, etc. may be mentioned. As a specific example of the halo alcohols, 1,3-dichloro-2-propanol, 2-chloroethanol, 1-chlorobutanol, etc. may be mentioned.
As an activity regulator when a metal carbene complex is used as a metathesis catalyst, Lewis base compounds may be mentioned. As a Lewis base compound, tricyclopentyl phosphine, tricyclohexyl phosphine, triphenylphosphine, triphenyl phosphite, n-butylphosphine and other Lewis base compounds having a phosphorous atom; and n-butylamine, pyridine, 4-vinylpyridine, acetonitrile, ethylene diamine, N-benzylidene methylamine, pyrazine, piperidine, imidazol and other Lewis base compound having a nitrogen atom; may be mentioned. Also, vinylnorbornene, propenylnorbornene, isopropenylnorbornene and other norbornenes substituted by an alkenyl group act as not only the above norbornene-based monomer, but also as an activity regulator. The amount of these activity regulators varies according to the compound used, and is not constant.

As an elastomer, for example, natural rubber, polybutadiene, polyisoprene, styrene-butadiene copolymer (SBR), styrene-butadiene-styrene block copolymer (SBS), styrene-isoprene-styrene copolymer (SIS), ethylene-propylene-diene terpolymer (EPDM), ethylene-vinyl acetate copolymer (EVA) and hydrogenated products of these, etc. may be mentioned. By using an elastomer which is dissolved in the reaction mixture, the viscosity of the reaction mixture can be controlled. Also, by adding an elastomer, the impact resistance of the resulting molded article can be improved. The amount of the elastomer is usually 0.5 to 20 parts by weight and preferably 2 to 10 parts by weight with respect to 100 parts by weight of the norbornene-based monomer in the reaction mixture.

As an antioxidizing agent, various types of those for plastics or rubbers such as phenol based agents, phosphorus based agents and amines based agents may be mentioned.

### Preparation of Reaction Stock Solution

Reaction stock solutions are prepared by dividing each of the above components into two or more portions. As a combination of the two or more reaction stock solutions, the following two types, (a) and (b), may be mentioned according to the kind of used metathesis catalyst.

That is; (a) : in case of the use of a metathesis catalyst which can exhibit polymerization activity in combination with an activator, but not only by itself, a reaction stock solution (a1) including a norbornene-based monomer and an activator; and another reaction stock solution (a2) including a norbornene-based monomer and a metathesis catalyst are separately prepared as reaction stock solution. Then, these reaction stock solutions can be used and mixed to obtain, the above mentioned reaction mixture. Further, a reaction stock solution (a3) including a norbornene-based monomer and none of a metathesis catalyst and an activator can be used together.

Also; (b): in case of the use of a metathesis catalyst which can be exhibit polymerization activity only by itself, a reaction stock solution (b1) including a norbornene-based monomer and a reaction stock solution (b2) including a metathesis catalyst are separately prepared, as reaction stock solutions. Then, these reaction stock solutions are used and mixed to obtain, the above mentioned reaction mixture. As the reaction stock solution (b2) in this case, a metathesis catalyst is usually used by dissolving or dispersing in a small amount of inactive solvent.

Note that, in either case of (a) or (b), the hybrid filler can be included in any reaction stock solution, however it is preferably included in the reaction stock solution comprising norbornene-based monomer. That is, in case of the (a), it can be included in 1 or 2 or more of the reaction stock solution of (a1), (a2) and (a3); but the hybrid filler is preferably included in (a2) or (a3) because it is easier to control the reaction. Also, in case of the (b), it is preferably included in the reaction stock solution (b1).

The content of the hybrid filler in the reaction stock solution is preferably 20 to 80 wt%, and further preferably 35 to 70 wt%. In the present invention, since the filler is added into reaction stock solution as the hybrid filler, the dispersibility of the filler into the reaction stock solution can be improved, as a result, even when the filler is added in relatively large amount, the viscosity of the stock solution can be made low and the stock solution can have good storing stability. Also, by increasing the added amount of the hybrid filler in the reaction stock solution, the added amount in the resulting molded article can be increased as well, which enables to further improve the rigidity and the dimensional stability of the molded article.

### Reaction Injection Molding

The reaction injection molding is performed by mixing the above mentioned two or more reaction stock solutions, and injecting the obtained reaction mixture into the mold followed by bulk polymerizing the norbornene-based monomer in the mold. Then, as a result of the bulk polymerization, the norbornene-based resin molded article of the present invention can be obtained.

In the method of production of the present invention, a known collisional mixer, used as a reaction injection molding (RIM) machine in the related arts, can be used to mix the reaction stock solutions. And, two or more reaction stock solutions are instantly mixed by a mixing head of the RIM machine, the obtained reaction mixture is injected in a mold, and bulk polymerized in the mold. Also, a dynamic mixer, a static mixer and other low-pressure injection machines can be used instead of the collisional mixer.

The mold used for reaction injection molding is not necessarily an expensive metal mold with high rigidity, and a resin mold or simple mold form can be used as well as a metal mold. This is because the reaction injection molding can be performed using reaction stock solutions with low viscosity at relatively low temperatures and pressures. Also, it is preferable to substitute the inside of the mold with inactive gas such as nitrogen gas before injecting the reaction mixture.

The mold temperature is preferably 10 to 150 °C, more preferably 30 to 120 °C and further preferably 50 to 100 °C. The clamping pressure is usually within the range of 0.01 to 10 MPa. The time of the bulk polymerization can be selected accordingly; however it is usually 20 seconds to 20 minutes, preferably 20 seconds to 5 minutes after completing the injection of the reaction stock solutions.

In the present invention, the complex giving member may be placed in the mold, and the norbornene-based resin molded article of the present invention can be a complex molded article co-formed with the complex giving member. Here, "co-formed" indicates that norbornene-based resin and complex giving member is bonded so that they cannot be detached easily. They can be bonded by resin fusion, or can be bonded via adhesive layer.

The complex giving member used in the present invention is a material that can be placed in the mold and have no fluidity at the mold temperature when bulk polymerizing. As a material of the complex giving member, metal, glass, ceramics, woods and other inorganic materials; and resin, rubber and other organic materials; may be mentioned. As the inorganic material, a metal or glass is preferable. As the organic material, a resin is preferable. As the resin, polyolefin resin, acrylic resin, ABS resin, vinyl chloride resin, unsaturated polyester resin, melamine resin, epoxy resin, phenol resin, polyurethane resin, polyamide resin, norbornene-based resin, etc. may be mentioned. Acrylic resin is particularly preferable among these.

The shape of the complex giving member is not particularly limited, and it can be anything from sheet, board, stick, woven or nonwoven, and various types of three-dimensional shapes and etc.

When the norbornene-based resin is firmly bonded to the complex giving member via an adhesive layer, the adhesive layer may be formed on at least a part of the surface of the complex giving member that is exposed to the reaction mixture. The material used to form the adhesive layer is not particularly limited as far as it does not disturb the bulk polymerization, and varies according to the used complex giving member, but it is preferable for the material to include a block copolymer of styrene and conjugated diene, or its hydride. As a specific example of such a block copolymer, styrene-butadiene block copolymer (SB), styrene-isoprene block copolymer(SI), styrene-butadiene-styrene block copolymer (SBS), styrene-isoprene-styrene block copolymer (SIS), styrene-butadiene-isoprene-styrene block copolymer (SBIS), etc. may be mentioned. Since adhesiveness between the norbornene-based resin and the complex giving member is high, it is preferable to bond them via the adhesive layer.

### Norbornene-based resin molded article

The molded article of the present invention can be obtained as mentioned above. The content of the hybrid filler as the filler in the molded article of the present invention is preferably 5 to 35 wt%, and more preferably 10 to 30 wt% with respect to 100 wt% of the whole molded article. However, when the molded article of the present invention is a complex molded article co-formed with a complex giving member, the above range indicates the content in the norbornene-based resin portion excluding the complex giving member. If the content of the hybrid filler as the filler is too large, the impact resistance of the molded article may decline. On the other hand, if too small, the rigidity and dimensional stability of the molded article may be insufficient.

### Norbornene-based resin molded article having the plating layer on its surface

The norbornene-based resin molded article of the present invention preferably has the plating layer which is formed on the surface of the article due to the high adhesiveness between the article and the plating layer. The norbornene-based resin molded article formed with the plating layer on its surface is formed by performing plating treatment on the surface of the norborene-based resin molded article. Note that, the thickness of the plating layer is preferably 10 to 300 µm and particularly preferably 50 to 150 µm.
The method of plating treatment for forming the plating layer is not particularly limited, however in the present invention the method is preferably the method comprising the steps of; first, forming the first plating layer (chemical plating layer) on the surface of norbornene-based resin molded article by chemical plating (electroless plating); and then forming the second plating layer (chemical plating layer) on the first plating layer by electrolytic plating (electroplating) . That is, the plating layers according to the present invention is preferably composed of first plating layer formed by chemical plating; and second plating layer formed by electrolytic plating.
Following will describe the method of formation of the plating layer in the present invention.

First, in the present invention, before performing the chemical plating on the surface of the norbornene-based resin molded article, norbornene-based resin molded article is subject to a pre-treatment. As for such pre-treatment, de-waxing step, chemical etching step, sensitizing step, activating step and the like may be mentioned. In the present invention, as for such pre-treatment methods, general method is applied.

Specifically, first, the de-waxing treatment of the surface of the resulting norbornene-based resin molded article is performed (the de-waxing step) . The de-waxing step is a step removing the waxy stain attached on the surface of the resin molded article by the method such as an alkaline, a solvent de-waxing, an emulsion de-waxing, an electrolytic de-waxing,a mechanical de-waxing and etc.

Next, the chemical etching is performed to the norbornene-based resin molded article after the de-waxing treatment (the chemical etching step) . In the chemical etching step, a chemical etching solution including; sulfuric acids, nitric acids, hydrochloric acids, acetic acids, chromic acids, phosphoric acids, manganese peroxides compounds, chromic acid compounds, ferric chloride compounds and etc. is used.

Then, a sensitizing and an activating (sensitizing step and activating step) are performed to the norbornene-based resin molded article after the chemical etching is performed. In the sensitizing step and activating step; the norbornene-based resin molded article is immersed in the solution which is prepared by dissolving silver, palladium, zinc, cobalt and other metals and salt or complex thereof in water or an organic solvent such as alcohol or chloroform in a concentration of 0.001 to 10 wt% with optionally including acid, base, complexing agent and reducing agent , thereafter the metal is reduced whereby the plating catalyst is adhered to the surface of the norbornene-based resin molded article and activated.

After the above mentioned pre-treatment to the norbornene-based resin molded article is performed, the norbornene-based resin molded article is immersed in a plating vessel containing chemical plating solution for chemical plating to form the first plating layer. The conditions of the chemical plating are selected accordingly depending on the plating solution.

The plating solution used in the chemical plating is not particularly limited; however, a known an electroless plating solution of autocatalytic type can be used.
For example, an electroless copper plating solution having ammonium hypophosphorous acid, hypophosphorous acid, ammonium hydroboron, hydrazine, formalin or so as a reducing agent; an electroless nickel-phosphorus plating solution having sodium hypophosphorous acid or so as a reducing agent; an electroless nickel-boron plating solution having dimethyl aminoboron as a reducing agent; an electroless paradium plating solution; an electroless paradium-phosphorous plating solution having sodium hypophosphorous acid as a reducing agent; an electroless gold plating solution, an electroless silver solution; an electroless nickel-cobalt-phosphorous plating solution having sodium hypophosphorous acid as a reducing agent and other electroless plating solution can be used. Also, these electroless plating solutions may be suitably added with tartaric acid, ethylenediaminetetraacetic acid, citric acid, acetic acid and other prior known complexing agent; a buffer agent such as boric acid; a pH adjustor such as sodium hydroxide; and the like for controlling the stability of the plating solution and the speed of plating precipitate.

Next, the norbornene-based resin molded article formed with the first palting layer by a chemical plating was subject to electrolytic plating to form the second plating layer over the first plating layer.
The method of an electrolytic plating is not particularly limited, and a known method can be applied. Also, the second plating layer formed by the electrolytic plating can be made as a single layer film of a single metal or a multilayer film made by metals of plurality types. Also, the metal constituting the second plating layer is not particularly limited; and for example, copper, silver, nickel, gold, tin, cobalt and chrome or so may be mentioned. However, it can be determined accordingly depending on the use of the final product of the resulting norbornene-based resin molded article.

The plating layer (the first plating layer and the second plating layer) according to the present invention may be formed covering the entire surface of the norbornene-based resin molded article or may be formed on the surface of the norbornene-based resin molded article in an arbitrary pattern. As for the method of forming the plating layer in an arbitrary pattern; (1) a method comprising the steps of: first forming the first plating layer over the entire surface of the norbornene-based resin molded article by the chemical plating forming resist pattern by using plating resist thereon, forming the second plating layer by electrolytic plating via resist pattern, and then removing the resists and the unnecessary part of the first plating layer by further etching to form the plating layer with pattern. Alternatively, (2) a method comprising steps of: first, forming a first plating layer having a desired pattern by performing a chemical plating in a desired pattern over the surface of the norbornene-based resin molded article, then forming the second plating layer over the patterned first plating layer may be mentioned. Note that, when the second layer is a multilayer film made by metals of plurality types, a method comprising the steps of: performing the resist removal and etching after forming one or two or more types of the metal layers constituting the second plating layer, and thereafter forming the rest of the metal layer may be applied.

The norbornene-based resin molded article of the present invention formed with the plating layer on its surface is obtained as such is excellent in high rigidity, and good dimensional stability; and is given with superior aesthetic quality due to the plating layer. Furthermore, the article also has a characteristic that the adhesiveness between the norbornene-based resin molded article and the plating layer is high. Moreover, the molded article can be suitably used for; the electronic element materials such as a prepregs, a circuit board for printing, an insulation sheet, an interlayer insulator, and an antenna substrate; a housing equipments such as kitchen sink and kitchen counter; and a molded article having a decorative plating such as a bumper.

### EXAMPLES

Hereafter, the present invention will be described based on the examples. However, the present invention is not limited to these examples. Note that, part and % in the following examples and comparative examples refers to weight-based units unless particularly stated. Also, each characteristic was measured by the method indicated in the followings.

### The viscosity of the filler dispersion

The viscosity of the filler dispersion (the reaction stock solutions including the filler) was measured, after one minute mixing by using type B viscometer with No.22 rotor at rotation speed of 60 rpm under the solution temperature at 25°C.

### Bending elastic constant

The bending elastic constant of the norbornene-based resin molded article was measured in accordance with JIS K 7171.

### Linear expansion coefficient

The linear expansion coefficient of the norbornene-based resin molded article was measured according to JIS K 7197. Note that, as a testing specimen, the one with the length of 10mm, the width of 5mm, and the thickness of 4mm was used for measurement.

### The adhesiveness between the norbornene-based resin molded article and a plating layer

The adhesiveness between the norbornene-based resin molded article and a plating layer of the norbornene-based resin molded article formed with the plating layer over the surface was evaluated by measuring the strength of adhesion according to JIS H 8630.

### Example 1

### Production of the Hybrid Filler

A wollastonite (made by Kinsei Matec Co. , Ltd, SH-400, 50% -volume cumulative diameter:20µm, aspect ratio:18) :75 parts as a fibrous filler and calcium carbonate (made by Sankyo Seifun Co.,Ltd., Escaron #2000; 50%-volume cumulative diameter:1.8µm, aspect ratio:1) : 25 parts as a particulate filler were introduced into the henschel mixer and mixed at rotation speed of 360 rpm under the tank temperature at 30°C. Next, into the mixer, 0.5 parts of a silane coupling agent (Shin-Etsu Chemical Co., Ltd., KBM-1003) was added by spraying, and mixed for 7 minutes at rotation speed of 720 rpm (circumferential speed of 40 m/s)after the spraying was completed. Then, the tank temperature was raised to 110 °C and mixed for 10 minutes at 360 rpm (circumferential speed of 20 m/s) to dry the filler. Next, into the mixer, 0.75 parts of a titanate coupling agent (made by Ajinomoto Fine-Techno.Co.Inc, PLENACT KR-TTS) was added by spraying. After the spraying was completed, it was mixed for 5 minutes at rotation speed of 360 rpm (circumferential speed of 20 m/s) to obtain the hybrid filler.

### Preparation of the filler dispersion

The mixture of norbornene-based monomer comprised of dicyclopentadiene: 90 parts and tricyclopentadiene: 10 parts were added with a hybrid filler produced in the above: 130 parts; and was shear dispersed under the condition of rotation speed of 13500 rpm for 10 minutes using homogenizer to obtain the filler dispersion comprising the norbornene-based monomer and the hybrid filler. The viscosity of the obtained filler dispersion was measured as the method mentioned in the above. The results are shown in Table 1.

### The production of norbornene-based resin molded article

First, the reaction stock solutions A and B (both made by RIMTEC Corporation, PENTAM#4000) were prepared. Note that, the reaction stock solution A comprises an activator, an activity regulator and an elastomer in addition to the mixture of the norbornene-based monomers; and the reaction stock solution B comprises a metathesis catalyst, an elastomer and an antioxidant in addition to the mixture of the norbornene-based monomers. Then, the prepared reaction stock solution B and the filler dispersion which prepared in the above were added so that the volume ratio becomes 1:1; and they were mixed uniformly to obtain the mixture solution. Here, the ratio was; 230 parts of the filler dispersion and 145 parts the reaction stock solution B.

Next, besides the above, two stainless plates having length of 260 mm X width of 240 mm were prepared and faced each other. A silicon packing having thickness of 4 mm and width of 15 mm was placed at the both end portions of the longitudinal directions and the one end portion of the lateral direction to form a simple metal mold having a space (cavity) of length of 245 mm X width of 210 mm X thickness of 4 mm. Then, the simple metal mold was vertically placed up with the side uncovered with silicon packing, and was drilled at the lowest part of one stainless plate to form an injection hole for reaction mixture. Also, heater wires were applied on all over the other stainless plate to be able to heat the simple metal mold.

Next, a gun static mixer having cartridge capacity of 2 : 1 was prepared. The cartridge with larger capacity was filled with the above made mixture solution, and the cartridge with the smaller capacity was filled with the reaction stock solution A. Next, the above made simple metal mold was heated to 80°C; and the mixture solution and the reaction stock solution A were injected into the heated simple metal mold while mixing with a static mixer to initiate the bulk polymerization. Note that, in the present examples, the volume ratio between the reaction stock solution A and the mixture was 1 : 2, and also the added amount of the hybrid filler was 25 parts, with respect to 100 parts of the whole reaction mixture (the norbornene-based resin molded article).

Then, after 2 minutes reaction, the simple metal mold was disassembled, and the norbornene-based resin molded article was obtained by taking the molded article out.
A test specimen with a length of 80mm, a width of 10mm, and a thickness of 4mm was cut out from the norbornene-based resin molded article to measure the bending elastic constant according to the above way. The results are shown in Table 2. In Table 2, E_{fx} indicates a measured value of the test specimen having length direction to be parallel to the longitudinal direction of the metal mold. Also, E_{fy} indicates a measured value of the test specimen having length direction to be parallel to the lateral direction of the metal mold. The larger E_{fx} and E_{fy} are, the higher the bending elastic constant and the rigidity are.
Another test specimen with a length of 10mm, a width of 5mm, and a thickness of 4mm was cut out from the norbornene-based resin molded article to measure the linear expansion coefficient according to the above way. The results are shown in Table 2. In Table 2, αₛₚₓ indicates a measured value of the test specimen having length direction to be parallel to the longitudinal direction of the metal mold. Also, α_{spy} indicates a measured value of the test specimen having length direction to be parallel to the lateral direction of the metal mold. The smaller the αₛₚₓ and α_{spy} are, the higher the dimensional stability is.

### Example 2

Except for changing the added amount of the hybrid filler to 170 parts during the preparation of the filler dispersion, the filler dispersion and norbornene-based resin molded article were obtained in the same way as in example 1. Then, the obtained filler dispersion and the norbornene-based resin molded article were each evaluated following the same method as in example 1. Note that, in example 2, each of the used amount of the reaction stock solution A and the reaction stock solution B were changed to 159 parts in order to make the volume ratio between the reaction stock solution A and the mixture solution to 1 : 2. Also, the added amount of the hybrid filler was 29 parts with respect to 100 parts of the whole reaction mixture (the norbornene-based resin molded article) . The results are shown in Table 2.

### Comparative example 1

Except for preparing the filler dispersion as in the following method, the filler dispersion and norbornene-based resin molded article were obtained in the same way as in example 1.
That is, in comparative example 1, first, the norbornene-based monomer consisting of dicyclopentadiene: 90 parts and trycyclopentadiene: 10 parts were added with wollastonite (made by Kinsei Matec Co.,Ltd; SH-400S) : 97.5 parts of which surface is pre-treated with silane coupling agent; calcium carbonate : 32.5 parts of which surface is pre-treated with silane coupling agent; and titanate coupling agent : 5.2 parts. These were shear dispersed using homogenizer for 10 minutes at a rotation speed of 13500rpm to prepare the filler dispersion.

Then, the obtained filler dispersion and the norbornene-based resin molded article were evaluated following the same method as in example 1. Note that, in the comparative example 1, the added amount of the hybrid filler was 25 parts, with respect to 100 parts of the whole reaction mixture (the norbornene-based resin molded article) . The results are shown in Table 2.

**Table 1**

| | | | Example 1 | Example 2 | Comparative example 1 |
|---|---|---|---|---|---|
| Mixture of monomer | | (parts by weight) | 100 | 100 | 100 |
| The mode of filler added | | | hybrid filler | hybrid filler | simple blended |
| | wollastonite | (parts by weight) | 97.5 | 127.5 | 97.5 |
| | Calcium carbonate | (parts by weight) | 32.5 | 42.5 | 32.5 |
| | Total amount of the filler | (parts by weight) | 130 | 170 | 130 |
| The content of filler in the filler solution | | (weight %) | 57 | 63 | 57 |
| The viscosity of the filler dispersion | | (mPa·s) | 320 | 640 | 810 |

**Table 2**

| | | | Example 1 | Example 2 | Comparative example 1 |
|---|---|---|---|---|---|
| Filler solution | Mixture of the monomer | (parts by weight) | 100 | 100 | 100 |
| | Total amount of the filler | (parts by weight) | 130 | 170 | 130 |
| Reaction liquid A | | (parts by weight) | 145 | 159 | 145 |
| Reaction liquid B | | (parts by weight) | 145 | 159 | 145 |
| The content of filler in the molded article | | (weight %) | 25 | 29 | 25 |
| Bending elastic constant | | | | | |
| E_{fx} (MPa) | | | 3740 | 4290 | 3270 |
| E_{fy} (MPa) | | | 2440 | 2590 | 2370 |
| Linear exansion coefficient | | | | | |
| αₛₚₓ (× 10⁻⁵/°C) | | | 2 | 2 | 3 |
| α_{spy} (× 10⁻⁵/°C) | | | 5 | 5 | 6 |

According to Table 1, the filler dispersion (the reaction stock solution) containing the hybrid filler as an filler in example 1 and 2 with the filler has a good dispersibility, therefore when compared with that of the comparative example 1 in which the filler dispersion was just simply mixed, it can be confirmed that the viscosity of the obtained filler dispersion in example 1 and 2 is lowered. Note that, the filler dispersion of the examples 1 and 2 had good storing stability. Particularly, from the result of example 2, even when the content of the hybrid filler was increased to 60% or more, it can be confirmed that good results can be obtained. On the other hand, the comparative example 1 wherein the filler is simply blended, the viscosity of the filler dispersion became high and also the storing stability was inferior.

According to Table 2, it can be confirmed that the norbornene-based resin molded article of example 1 and 2 has good bending elastic constant and linear expansion coefficient; and good rigidity and dimensional stability. Particularly, from the results of the example 2, it can be confirmed that further improvement of the bending elastic constant is possible by increasing the content of the hybrid filler. Also, it can be confirmed by comparing example 1 and comparative example 1 that even if the content of the filler was the same, the results of the bending elastic constant and linear expansion coefficient will be insufficient as long as the filler was simply blended.

### Example 3

### Production of the norbornene-based resin molded article

3 parts of stylene-isoprene-stylene block copolymer (Quintac 3421: made by Zeon Corporation) was dissolved in a mixture of a norbornene-based monomer consisting of 90 parts of dicyclopentadiene and 10 parts of tricyclopentadiene. Next, diethyl aluminum chloride as an activator and 1,3-dichloro-2-propanol as an activity regulator were added so that the concentration of each will be 100mmol/kg; and 0.1 parts of silicon tetrachloride was further added followed by uniform mixing and dispersing to obtain the reaction stock solution (solution A). The specific gravity of solution A was 0.98.

Apart from this, 3 parts of stylene-isoprene-stylene block copolymer (Quintac 3421) was dissolved in a mixuture of a norbornene-based monomer comprised of 90 parts of dicyclopentadiene and 10 parts of tricyclopentadiene. Next, 2 parts of phenol based antioxidant (IRGANOX1010: made by Ciba Specialty Chemicals Inc.) was dissolved, and tri(tridecyl) ammonium moribdate was added as a polymerization catalyst so that the concentration was 25 mmol/kg. Then it was uniformly mixed and dispersed to obtain reaction stock solution (solution B). The specific gravity of the solution B was 0.98.

Next, by high-speed mixing the fibrous filler and particulate filler in advance, it was made into hybrid filler to prepare the reaction stock solution (solution C).
That is, first, 135 parts of wallastonite (SH-400, Kinsei Matec Co.,Ltd; 50%-volume cumulative diameter:20µm, aspect ratio:18, surface treated by vinylsilane) as a fibrous filler; and 45 parts of calcium bicarbonate (made by Sankyo Seifun Co.,Ltd.; SCP-E #2300; 50%-volume cumulative diameter of 1.4µm, aspect ratio of 1, surface treated by stearic acid) as a particulate filler were introduced into 500L of henschel mixer; and it was mixed under the condition of tank temperature 30 °C and rotation speed of 360 rpm. Next, into the mixer, 0.5 parts of silane coupling agent (Shin-Etsu Chemical Co., Ltd., KBM-1003) was added by spraying and the resulting mixture was mixed for 7 minutes at rotation speed of 360 rpm (circumference speed 20m/s) . Then, the temperature inside the tank was raised to 110°C; and the resulting mixture was mixed for 10 minutes at rotation speed of 360 rpm (circumference speed 20m/s) to dry the filler. Next, into the mixer, 0.75 parts of titanate coupling agent (made by Ajinomoto Fine-Techno.Co.Inc, PLENACT KR-TTS) was added by spraying. After the spraying was completed, it was mixed for 5 minutes at the rotation speed of 360rpm(circumference speed 20m/s) to obtain the hybrid filler.
Then, the mixture of norbornene-based monomer consisting of 90 parts of dicyclopentadiene and 10 parts of tricyclopentadiene was added with 180 parts of the hybrid filler produced in the above. Then, by using the homogenizer, it was shear dispersed for 10 minutes at rotation speed of 13500rpm to obtain a reaction stock solution (liquid C) comprising the norbornene-based monomer and the hybrid filler.

The reaction injection molding metal mold comprising space (cavity) length of 500mm X width of 500 mm X thickness of 4 mm inside thereof was prepared, and one metal mold was heated to 90 °C and the other metal mold was heated to 60 °C. Then, the above prepared; 26.8 parts of solution A, 26.8 parts of solution B and 46.4 parts of solution C; were introduced into the mixing head, and injected into the reaction injection molding metal mold at injection pressure of 5 Mpa or less and the polymerization was performed for 3 minutes from the start. Here, the mixing volume ratio of solution A, solution B and solution C, was 1:1:1; and the amount of the fibrous filler injected was 22.5 parts and that of the particulate filler was 7.5 parts. Then, the norbornene-based resin molded article was taken out from the metal mold.

The resulting norbornene-based resin molded article was subject to measuring the bending elastic constant and linear expansion coefficient. The results are shown in Table 3.

### The formation of the plating layer

The norbornene-based resin molded article produced in the above was cut out into the size of length of 347mm X width of 210mm X thickness of 4mm. The resin molded article being cut was subject to the pre-treatment before the plating which is described in the following.

That is, first, the norbornene-based resin molded article being cut out was immersed in the solution, in per 1 litter, dissolved with 100ml of sulfuric acid and 1.5g of surfactant for 5 minutes at 50 °C to perform de-waxing treatment. Next, the norbornene-based resin molded article being de-waxed was immersed in the solution, in per 1 litter, dissolved with 100ml of sulfuric acid and 400g of chromic anhydride (chemical etching solution), for 5 minutes at 65 °C to perform chemical etching. Then, the norbornene-based resin molded article after chemical etching was treated with acid cleansing by using the solution, in per 1 litter, dissolved with 50ml of 35% hydrochloric acid, for 2 minutes at 25 °C. Next, the cleansed norbornene-based resin molded article was immersed in the solution, in per 1 litter, dissolved with 20g of tin dichloride (dihydrates) and 50ml of the solution dissolved with the 35% hydrochloric acid, for 5 minutes at 25°C to sensitize. Next, the norbornene-based resin molded article being sensitized was immersed into the solution, in per 1 litter, dissolved with 0.4g of palladium dichloride and 3ml of 35% hydrochloric acid, for 5 minutes at 25°C to activate.

Then, the activated norboenene-based resin molded article was immersed into a solution (pH 10), in per 1 litter, dissolved with 15g of nickel sulfate (hexahydrates), sodium citrate (dihydrates), 10g of sodium hypochlorite (monohydrate) and 3 ml of lactic acid to perform a chemical plating for 8 minutes at 40°C, and the chemical plating layer on the surface of the norbornene-based resin molded article was formed.

Furthermore, the norbornene-based resin molded article formed with the chemical plating layer was immersed in the solution, in per 1 litter, dissolved with 50ml of sulfuric acid, for 20 seconds at 25°C. Then, it was immersed in a solution, in per 1 litter, dissolved with 150g of copper sulfate (pentahydrates)and 60g of sulfuric acid; and was treated for 3 minutes at 25°C using copper cathode under the condition of anode current density of 2A/dm². Finally, it was immersed into a solution, in per 1 litter, dissolved with 200g of copper sulfate (pentahydrates), 60g of sulfuric acid and adequate amount of brightener; followed by electroplating using copper cathode for 30 minutes at 25°C under 4A/dm² to form brightening copper plating layer with the thickness of 40µm; and the norbornene-based resin molded article with the plating layer on the surface was obtained. The adhesive strength of said molded aticle was measured. The results are shown in Table 3.

### Example 4

Except for preparing the reaction stock solution (solution C) so that the fibrous filler and the particulate filler to be 15 parts and 5 parts, respectively, which is added as the hybrid filler; the norbornene-based resin molded article and the norbornene-based resin molded article formed with a plating layer over the surface were made and evaluated in the same way as in example 1. The results are shown in Table 3.

### Comparative example 2

Except for not adding the fibrous filler and the particulate filler during the preparation of the reaction stock solution (solution C); the norbornene-based resin molded article and the norbornene-based resin molded article formed with a plating layer over the surface were made and evaluated in the same way as in example 3. The results are shown in Table 3.

### Comparative example 3

Except for using aluminum hydroxide (made by Showa Denko K.K, HIGILITE H-34) instead of fibrous filler and the particulate filler; the norbornene-based resin molded article and the norbornene-based resin molded article formed with a plating layer over the surface were made and evaluated in the same way as in the example 3. Note that, the amount of aluminum hydroxide added was 30 parts, with respect to 100 parts of whole norbornene-based resin molded article. The results are shown in Table 3.

**Table 3**

| | Example 3 | Example 4 | Comparative example 2 | Comparative Example 3 |
|---|---|---|---|---|
| Fibrous filler | | | | |
| Aspect ratio | 18 | 18 | | |
| The amount in the norbornene-based resin molded article (weight %) | 22.5 | 15 | 0 | 0 |
| Particulate filler | | | | |
| Aspect ratio | 1 | 1 | | 1 |
| The amount in the norbornene-based resin molded article (weight %) | 7.5 | 5 | 0 | 30 |
| The total amount of filler in the norbomene-based resin molded article (weight %) | 30 | 20 | 0 | 30 |
| Norbomene-based resin molded article characteristics | | | | |
| Bending elastic constant | | | | |
| E_{fx} (GPa) | 4.5 | 3.7 | 1.9 | 2.3 |
| E_{fy} (GPa) | 3.5 | 2.5 | 1.9 | 2.3 |
| Linear exansion coefficient | | | | |
| αₛₚₓ (× 10⁻⁵/°C) | 2.1 | 2.7 | 7.5 | 5.7 |
| α_{spy} (× 10⁻⁵/°C) | 5.2 | 5.7 | 7.5 | 5.7 |
| Complex molded article characteristics | | | | |
| Adhesive strength of plating layer (kgf/cm) | 2.4 | 2.1 | 1.6 | 2.4 |

Followings can be confirmed from Table 3. That is, the norbornene-based resin molded article comprising a hybrid filler obtained by high-speed mixing two or more kinds of fillers in dry method; and the norbornene-based resin molded article formed with a plating layer over the surface; had good bending elastic constant, linear expansion coefficient, rigidity and dimensional stability. Furthermore, the adhesiveness between the norbornene-based resin molded article and the plating layer were also good (example 3 and 4)
On the other hand, when the filler was not added, it resulted in insufficient bending elastic constant and linear expansion coefficient; and inferior rigidity, dimensional stability and adherence (comparative example 2) . Moreover, when aluminum hydroxide was used as the filler, even though the adhesiveness between the norbornene-based resin molded article and the plating layer was relatively good, the bending elastic constant and linear expansion coefficient were insufficient; and rigidity and dimensional stability were inferior (comparative example 3).

## Claims

1. A norbornene-based resin molded article obtainable by bulk polymerizing a norbornene-based monomer in a mold wherein said norbornene-based resin molded article is **characterized by** comprising a hybrid filler obtainable by high-speed mixing two or more kinds of fillers in dry method.

2. The norbornene-based resin molded article according to claim 1 wherein said hybrid filler is a filler obtainable by high-speed mixing at least a fibrous filler having an aspect ratio of 5 to 100 and a particulate filler having an aspect ratio of 1 to 2, in dry method.

3. The norbornene-based resin molded article according to claim 2 wherein said fibrous filler is a wollastonite.

4. The norbornene-based resin molded article according to claim 2 or 3 wherein said particulate filler is a calcium carbonate.

5. The norbornene-based resin molded article according to any one of claims 2 to 4 wherein a ratio between said fibrous filler and said particulate filler is, in weight ratio, fibrous filler : particulate filler = 95 : 5 to 50 : 50.

6. The norbornene-based resin molded article according to any one of claims 1 to 5 wherein said hybrid filler is surface treated with a silane coupling agent and/or a titanate coupling agent.

7. The norbornene-based resin molded article according to any one of claims 1 to 6 wherein said norbornene-based resin molded article is a complex molded article co-formed with a complex giving member.

8. The norbornene-based resin molded article according to any one of claims 1 to 7 wherein a plating layer is formed on a surface of said norbornene-based resin molded article.

9. The norbornene-based resin molded article according to claim 8 wherein said plating layer comprises;
a first plating layer formed on the surface of said norbornene-based resin molded article by chemical plating, and a second plating layer formed on the surface of said first plating layer by electroplating.

10. A method of production of the norbornene-based resin molded article according to any one of claims 1 to 9 **characterised by** comprising the steps of,
injecting a reaction mixture comprising said norbornen-based monomer, a metathesis catalyst and said hybrid filler into a mold, and conducting bulk polymerization in the mold.

11. The method of production of the norbornene-based resin molded article according to claim 10 wherein a complex giving member is placed inside said mold.
